# EUROPEAN PATENT APPLICATION

(11) **EP 3 009 265 A1**
(43) Date of publication of application: **20.04.2016**
(21) Application number: 14811354.1
(22) Date of filing: 13.06.2014
(51) Int. Cl.: B32B 27/36, B32B 27/30, C08J 7/04

(54) **RESIN PRODUCT AND MANUFACTURING METHOD THEREOF**

(30) Priority: 14.06.2013 JP 2013125133
(71) Applicant: Kojima Industries Corporation, Toyota-shi, Aichi 471-0875 (JP)
(72) Inventor: OGURI, Yasuhiro, Toyota-shi Aichi 471-0875 (JP); MATSUI, Hirotoshi, Toyota-shi Aichi 471-0875 (JP)
(74) Representative: Smith, Matthew
(86) International application number: PCT/JP2014/065756
(87) International publication number: WO 2014/200092

(57) **Abstract**

A resin product in which an undercoat layer and a topcoat layer formed of a silicon compound are formed, in this order of description, on a surface of a resin substrate formed of polycarbonate, and which has a high degree of weather-proofness. The undercoat layer is formed of a mixture of: a silane coupling agent having a reactive functional group and a hydrolyzable organic group; and a fluorine-containing resin having a reactive group which can be bonded to the reactive functional group of the silane coupling agent. The reactive functional group of the silane coupling agent is bonded to the reactive group of the fluorine-containing resin, while the hydrolyzable organic group of the silane coupling agent is bonded to the silicon compound of the topcoat layer.

## Description

### TECHNICAL FIELD

The present invention relates to a resin product and a method of producing the same, and more particularly to a resin product suitably usable as a resin glass (organic glass), and a method which permits advantageous production of such resin product.

### BACKGROUND ART

A resin product having excellent formability and a light weight has been widely used as interior and exterior parts of an automotive vehicle or other vehicles, electric components, electronic components and architectural components, for example. Among those resin products, a highly transparent resin product in the form of a molded article of polycarbonate has been used as a resin glass (organic glass) which is used as an alternative to an inorganic glass to form a window glass of the automotive vehicle or other vehicles, various kinds of display, and covers of various kinds of measuring instrument, for example, since the molded article of polycarbonate has a lighter weight, a higher impact resistance and higher workability than the inorganic glass.

By the way, the resin product formed of polycarbonate has problems in terms of its weather-proofness. For example, the resin product formed of polycarbonate suffers from discoloration and deterioration of its strength when it is exposed to an ultraviolet ray. The resin product formed of polycarbonate has a further disadvantage that it is inferior to the inorganic glass in its wear- and scratch-resistance (wear resistance and scratch resistance). Accordingly, where the resin product formed of polycarbonate is used as the window glass of the automotive vehicle or other article which is used outdoors and in which a scratch and a flaw on its surface become serious defects, it is necessary to take measures for improving the weather-proofness and the wear- and scratch-resistance of the resin product.

Under the above-described circumstances, JP-A-2010-253683 (Patent Document 1) discloses a resin product (resin molded article) in which an undercoat layer in the form of a thin film of an acrylic resin or the like is formed on a surface of a resin substrate in the form of a molded article of polycarbonate or the like, to improve the weather-proofness of the resin product, and a topcoat layer in the form of a plasma CVD layer of a silicon compound is formed on the undercoat layer, to improve the wear- and scratch-resistance of the resin product.

However, the inventors of the present invention evaluated, by ultraviolet irradiation, the weather-proofness of the resin product in which the undercoat layer in the form of the thin film of the acrylic resin and the topcoat layer in the form of the plasma CVD layer of the silicon compound are formed, in this order of description, on the surface of the resin substrate formed of polycarbonate, and found that the resin product irradiated with the ultraviolet ray sometimes suffers from peeling of the topcoat layer from the undercoat layer and cracking of the topcoat layer and the undercoat layer. Thus, it was revealed that the conventional resin product as disclosed in the above-indicated publication has a room for further improvement of its weather-proofness.

### PRIOR ART DOCUMENT

### PATENT DOCUMENT

Patent Document 1: JP-A-2010-253683

### SUMMARY OF THE INVENTION

### TECHNICAL PROBLEM

The present invention was made in view of the background art described above. It is therefore an object of the invention to provide a resin product in which an undercoat layer and a topcoat layer formed of a silicon compound are formed on a surface of a resin substrate formed of polycarbonate, which resin product can exhibit improved weather-proofness. Another object of the invention is to provide a method which permits advantageous production of the resin product which can exhibit the improved weather-proofness.

### SOLUTION TO PROBLEM

In order to achieve the above-described objects, the inventors of the present invention made intensive studies on the resin product having the structure in which the undercoat layer and the topcoat layer formed of the silicon compound are formed on the surface of the resin substrate formed of polycarbonate, and found that the problems caused by the ultraviolet irradiation of the resin product, such as cracking of the undercoat layer and the topcoat layer and peeling of the topcoat layer from the undercoat layer, can be advantageously solved by forming the undercoat layer by using a mixture of a silane coupling agent and a fluorine-containing resin, wherein the silane coupling agent has: a reactive functional group which reacts with an organic matter and contributes to bonding to the organic matter; and a hydrolyzable organic group (hereinafter referred to as a "hydrolyzable group") which reacts with an inorganic matter after it is hydrolyzed and contributes to bonding to the inorganic matter, while the fluorine-containing resin has a reactive group which can be bonded to the reactive functional group of the silane coupling agent. The above-described problems are solved presumably for reasons described below.

A fluorine atom is larger than a carbon atom. Accordingly, when the resin product is irradiated with the ultraviolet ray, the ultraviolet ray is blocked by the fluorine atoms in parts of the fluorine-containing resin of the undercoat layer, in which parts, the fluorine atoms and the carbon atoms are bonded to each other. The ultraviolet ray is also blocked by the fluorine atoms as far as possible, in parts of the fluorine-containing resin of the undercoat layer, in which parts, atoms other than the fluorine atoms and the carbon atoms are bonded to each other. Further, a bond energy between the fluorine atom and the carbon atom is larger than an ultraviolet energy. Accordingly, the bonds between the fluorine atoms and the carbon atoms, which bonds constitute a main organic backbone of the fluorine-containing resin of the undercoat layer, are not cut by the ultraviolet irradiation of the resin product. Cutting of the bonds between the atoms other than the fluorine atoms and the carbon atoms by the ultraviolet irradiation are also effectively reduced or prevented. It is considered that cracking of the undercoat layer due to the ultraviolet irradiation is prevented for the above-described reasons.

The hydrolyzable group of the silane coupling agent forms a siloxane bond together with a reactive group of the silicon compound of the topcoat layer, which siloxane bond has a bond energy larger than the ultraviolet energy. On the other hand, the reactive functional group of the silane coupling agent forms a strong bond together with the reactive group of the fluorine-containing resin of the undercoat layer. It is considered that adhesiveness between the undercoat layer and the topcoat layer is advantageously increased for the above-described reasons, resulting in advantageous prevention of the problems of: 1) peeling of the topcoat layer from the undercoat layer; and 2) cracking of the topcoat layer caused by its peeling from the undercoat layer, which problems would otherwise be caused by the ultraviolet irradiation of the resin product.

The present invention was completed based on the above-described finding, and provides a resin product wherein an undercoat layer in the form of a resin thin film is formed on a surface of a resin substrate in the form of a resin molded article of polycarbonate, and a topcoat layer is formed of a silicon compound on the undercoat layer, characterized in that: the undercoat layer is formed of a mixture of: a silane coupling agent having a reactive functional group and a hydrolyzable organic group; and a fluorine-containing resin having a reactive group which can be bonded to the reactive functional group of the silane coupling agent; the reactive functional group of the silane coupling agent is bonded to the reactive group of the fluorine-containing resin; and the hydrolyzable organic group of the silane coupling agent is bonded to the silicon compound of the topcoat layer.

In one preferred form of the invention, the reactive functional group of the silane coupling agent is an isocyanate group or an epoxy group, and the reactive group of the fluorine-containing resin is a hydroxyl group.

The invention also provides a method of producing a resin product wherein an undercoat layer in the form of a resin thin film is formed on a surface of a resin substrate in the form of a resin molded article of polycarbonate, and a topcoat layer is formed of a silicon compound on the undercoat layer, the method comprising the steps of: (a) providing the resin substrate; (b) forming the undercoat layer on the surface of the resin substrate by using a mixture of: a silane coupling agent having a reactive functional group and a hydrolyzable organic group; and a fluorine-containing resin having a reactive group which can be bonded to the reactive functional group of the silane coupling agent, such that the reactive functional group of the silane coupling agent is bonded to the reactive group of the fluorine-containing resin; and (c) forming the topcoat layer on the undercoat layer by using the silicon compound, such that the silicon compound is bonded to the hydrolyzable organic group of the silane coupling agent contained in the undercoat layer.

### ADVANTAGEOUS EFFECTS OF THE INVENTION

In the resin product according to the invention, problems of cracking of the undercoat layer and the topcoat layer, and peeling of the topcoat layer from the undercoat layer, which problems would otherwise be caused by the ultraviolet irradiation of the resin product, can be advantageously solved, so that the resin product can extremely effectively exhibit further improved weather-proofness.

By the method of producing the resin product according to the invention, the resin product which can exhibit a higher degree of weather-proofness than the conventional resin product can be industrially advantageously produced.

### BRIEF DESCRIPTION OF THE DRAWINGS

Fig. 1 is a schematic cross sectional view showing a part of a resin product having a structure according to one embodiment of the invention;
Fig. 2 is an enlarged schematic view showing a part of the resin product shown in Fig. 1;
Fig. 3 is a schematic view showing an example of a step of production of the resin product shown in Fig. 1, in which step, uncured undercoat layers are formed on surfaces of a resin substrate; and
Fig. 4 is a schematic view showing a step implemented following the step shown in Fig. 3, in which step, topcoat layers are formed on the undercoat layers formed on the surfaces of the resin substrate.

### MODE FOR CARRYING OUT THE INVENTION

To clarify the invention more specifically, an embodiment of the invention will be described by reference to the drawings.

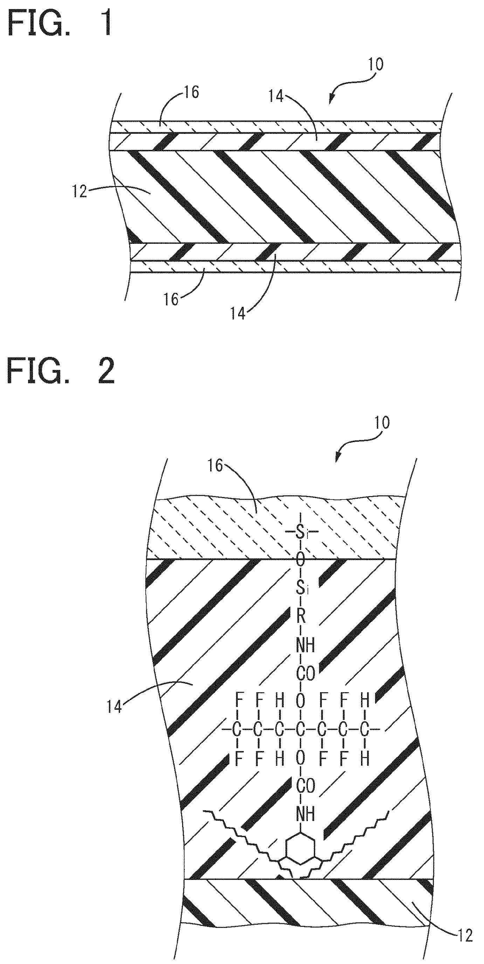

Referring first to the cross sectional view of Fig. 1, there is shown a part of a resin glass 10 for a rear-window of an automotive vehicle, which has a structure according to one embodiment of the invention. As is apparent from Fig. 1, the resin glass 10 has a resin substrate 12, and undercoat layers 14 are formed on respective front and back surfaces (upper and lower surfaces as seen in Fig. 1) of the resin substrate 12, while topcoat layers 16 are formed of a silicon compound on surfaces of the undercoat layers 14, which surfaces are remote from the resin substrate 12. For the sake of convenience, the upper surface of the resin substrate 12 as seen in Fig. 1 is hereinafter referred to as the front surface, while the lower surface of the resin substrate 12 as seen in Fig. 1 is hereinafter referred to as the back surface.

The resin substrate 12 is a resin molded article in the form of a transparent flat plate formed of polycarbonate by injection molding. The resin substrate 12 may be formed by a method other than the injection molding, as long as the resin substrate 12 is formed of polycarbonate. A thickness of the resin substrate 12 is not particularly limited, and adequately selected depending on the intended application of the resin glass 10 and properties required for the resin glass 10, for example. In this embodiment, the resin substrate 12 has the thickness of about 2-7mm.

The undercoat layers 14 are thin films which are directly formed on the respective front and back surfaces of the resin substrate 12, such that the entire front and back surfaces of the resin substrate 12 are covered by the undercoat layers 14, in order to give a high weather-proofness based on a high ultraviolet resistance and the like, to the resin glass 10.

A thickness of each of the undercoat layers 14 is not particularly limited, but is generally about 1-40µm. Where the thickness of the undercoat layer 14 is smaller than 1µm, there arises a risk of difficulty in giving a sufficiently high weather-proofness to the resin glass 10, due to the excessively small thickness of the undercoat layer 14. On the other hand, even where the thickness of the undercoat layer 14 is increased so as to be larger than 40µm, further improvement of the weather-proofness of the resin glass 10 is difficult to be achieved, and there even arise risks of wasting of the material and an undesirable increase of a time required for forming the undercoat layer 14. Each of the undercoat layers 14 may have either of a single-layer structure and a multi-layer structure consisting of a plurality of layers superposed on each other.

The topcoat layers 16 are thin films which are formed so as to cover the entireties of the surfaces of the respective undercoat layers 14, which surfaces are remote from the substrate 12, in order to give a high wear- and scratch-resistance to the resin glass 10. In this embodiment, the topcoat layers 16 are plasma CVD layers of SiO₂ which exhibit an excellent wear- and scratch-resistance. Although the material of the topcoat layers 16 is not particularly limited as long as the topcoat layers 16 can give a sufficiently high wear- and scratch-resistance to the resin glass 10, silicon compounds such as SiON and Si₃N₄ are generally used, as well as SiO₂, as the material of the topcoat layers 16.

Although an entire thickness of each of the topcoat layers 16 is not particularly limited, the thickness of the topcoat layer 16 is preferably about 1-20µm, to give a sufficiently high wear- and scratch-resistance to the resin glass 10, without an unnecessary increase of the entire thickness of the topcoat layer 16. Each of the topcoat layers 16 may have either of the single-layer structure and the multi-layer structure consisting of a plurality of layers superposed on each other.

The resin glass 10 of this embodiment has major technical characteristics in its undercoat layers 14.

Namely, the undercoat layers 14 of the resin glass 10 of this embodiment are formed of a mixture of: 1) a silane coupling agent having a reactive functional group and a hydrolyzable organic group (hydrolyzable group) which contributes to bonding to an inorganic matter in the form of the silicon compound, after it is hydrolyzed; and 2) a fluorine-containing resin having a reactive group which can be bonded to the reactive functional group of the silane coupling agent. In other words, the undercoat layers 14 are formed of the fluorine-containing resin containing the silane coupling agent.

More specifically described, in this embodiment, the silane coupling agent having the reactive functional group in the form of an isocyanate group (-NCO group) and the hydrolyzable group in the form of a methoxy group (-OCH₃ group) is used as the silane coupling agent contained in the undercoat layers 14. The reactive functional group and the hydrolyzable group of the silane coupling agent contained in the undercoat layers 14 are not limited to those described above. The reactive functional group may be an epoxy group (-CHOCH₂ group) or the like, and the hydrolyzable group (hydrolyzable organic group) may be an ethoxy group (-OC₂H₅ group), an acetyl group (-OCOCH₃ group) or the like.

On the other hand, a fluorine-containing urethane resin is used as the fluorine-containing resin which constitutes the undercoat layers 14 together with the silane coupling agent. In this embodiment, the fluorine-containing urethane resin is a reaction product (polymer) obtained by reacting a base agent having a structure represented by Chemical Formula 1 indicated below, with a curing agent having a structure represented by Chemical Formula 2 indicated below. The base agent is a copolymer of tetrafluoroethylene and an ethylene-based compound in which two of four hydrogen atoms of ethylene are substituted with hydroxyl groups (-OH groups), while the curing agent is an isocyanurate body of hexamethylenediisocyanate. Namely, the undercoat layers 14 are formed of the fluorine-containing urethane resin having the hydroxyl group which can be bonded to the isocyanate group as the reactive functional group of the silane coupling agent. Further, the fluorine-containing urethane resin has a number of bonds between fluorine atoms and carbon atoms, which bonds have a bond energy larger than the ultraviolet energy. A bonding form of a fluorine monomer and the ethylene-based compound in the base agent is not particularly limited.

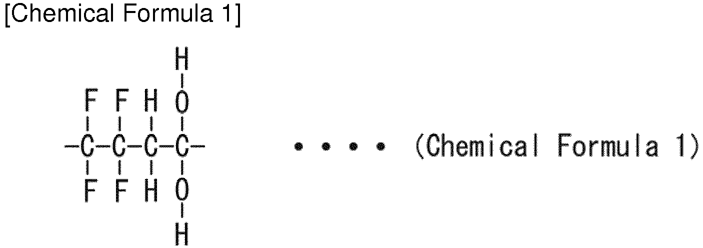

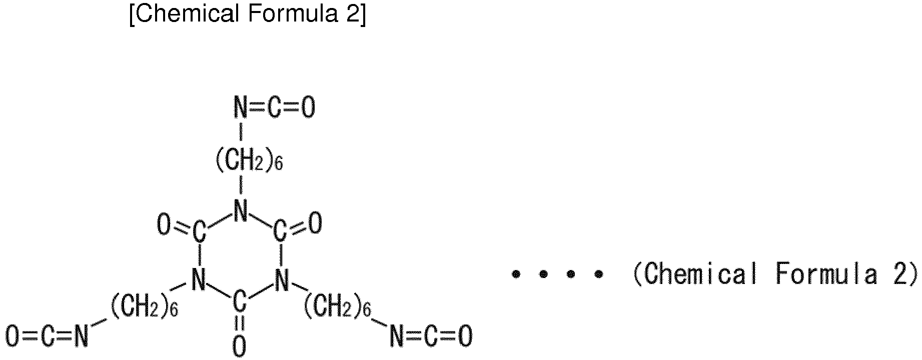

The fluorine monomer having a double bond is generally used as the fluorine monomer of the base agent used for forming the fluorine-containing urethane resin. Examples of the generally used fluorine monomer include vinyl fluoride, vinylidene fluoride and 1,1,2-trifluoroethylene, as well as tetrafluoroethylene. As the ethylene-based compound to be polymerized with the fluorine monomer, there are used compounds in which some of the four hydrogen atoms of ethylene are substituted with a reactive group which can be bonded to the reactive functional group of the silane coupling agent.

The fluorine-containing resin of the undercoat layers 14 is not limited to the fluorine-containing urethane resin described above, as long as the fluorine-containing resin has the reactive group which can be bonded to the reactive functional group of the silane coupling agent, and a high ultraviolet resistance. Examples of the fluorine-containing resin which can be used to form the undercoat layers 14 include a fluorine-containing acrylic resin, a fluorine-containing acrylic urethane resin, a fluorine-containing silicone resin, a fluorine-containing acrylic silicone resin, a polyvinyl fluoride, a polyvinylidene fluoride, and a perfluoroalkoxy fluorine resin, which resins have the reactive group which can be bonded to the reactive functional group of the silane coupling agent. The fluorine-containing resins indicated above are not limited by types of their curing, and may be heat curable resins and ultraviolet curable resins, for example.

The reactive group of the fluorine-containing resin which can be bonded to the reactive functional group of the silane coupling agent is adequately selected depending on the reactive functional group of the silane coupling agent. In the case where the fluorine-containing resin other than the fluorine-containing urethane resin is used, a predetermined reactive group of the fluorine-containing resin is substituted with the reactive group which can be bonded to the reactive functional group of the silane coupling agent, to introduce the latter reactive group in the fluorine-containing resin.

In this embodiment, the undercoat layers 14 are formed of the mixture of the silane coupling agent and the fluorine-containing urethane resin in which one of the two hydroxyl groups of the base agent in the form of the copolymer of the ethylene-based compound and tetrafluoroethylene is bonded to an isocyanate group of the curing agent in the form of the isocyanurate body of hexamethylenediisocyanate, as shown in Fig. 2.

In the undercoat layers 14, the isocyanate group as the reactive functional group of the silane coupling agent is bonded to the other of the two hydroxyl groups of the base agent of the fluorine-containing urethane resin, which hydroxyl group is not bonded to the isocyanate group of the curing agent. Thus, the fluorine-containing urethane resin and the silane coupling agent are strongly bonded to each other in the undercoat layers 14.

Further, the silane coupling agent in the undercoat layers 14 has a silanol (Si-OH) generated when the methoxy group as the hydrolyzable group of the silane coupling agent is hydrolyzed with water contained in a solvent of the silane coupling agent. Accordingly, a siloxane bond (Si-O-Si) is formed between the undercoat layers 14 containing the silane coupling agent and the topcoat layers 16 in the form of the plasma CVD layers of SiO₂, by a condensation reaction between the silanol derived from the hydrolyzable group of the silane coupling agent and a silanol in the topcoat layers 16. Thus, the sliane coupling agent strongly bonded to the fluorine-containing urethane resin in the undercoat layers 14 is also strongly bonded to the topcoat layers 16 by a bond energy larger than the ultraviolet energy.

A size of the fluorine atoms in the fluorine-containing urethane resin is sufficiently larger than that of the hydrogen atoms and the carbon atoms. Accordingly, in the resin glass 10 having the undercoat layers 14 formed of the fluorine-containing urethane resin, when the undercoat layers 14 are irradiated with the ultraviolet ray via the topcoat layers 16, the ultraviolet ray is blocked by the fluorine atoms in parts of the fluorine-containing urethane resin of the undercoat layers 14, in which parts, the fluorine atoms and the carbon atoms are bonded to each other. The ultraviolet ray is also blocked by the fluorine atoms as far as possible, in parts of the fluorine-containing urethane resin of the undercoat layers 14, in which parts, the oxygen atoms and the carbon atoms are bonded to each other.

The resin glass 10 having the above-described structure is produced by the steps described below, for example.

Initially, the resin substrate 12 in the form of the flat plate is formed of a polycarbonate resin by injection molding or the like.

Then, a liquid mixture is prepared by mixing: the base agent in the form of a solution (e.g., butyl acetate solution) of the copolymer of tetrafluoroethylene and the ethylene-based compound in which the two of four hydrogen atoms of ethylene are substituted with the hydroxyl groups (-OH groups); the curing agent in the form of a solution (e.g., butyl acetate solution) of the isocyanurate body of hexamethylenediisocyanate; and a solution (e.g., aqueous solution) of the silane coupling agent having the isocyanate group (-NCO group) as the reactive functional group and the methoxy group (-OCH₃ group) as the hydrolyzable group.

In this respect, it is noted that although a mixing ratio (compounding ratio) of the base agent, the curing agent and the silane coupling agent is not particularly limited, 10-30 parts by weight of the curing agent and 2-5 parts by weight of the silane coupling agent are generally used with respect to 100 parts by weight of the base agent. Where the curing agent is used in an amount more than 30 parts by weight with respect to 100 parts by weight of the base agent, the undercoat layers 14 may become brittle, and may have a poor appearance due to a reaction caused between an excess of the curing agent and water. Where the curing agent is used in an amount less than 10 parts by weight with respect to 100 parts by weight of the base agent, there arise risks of insufficient curing of the undercoat layers 14 and insufficient adhesiveness of the undercoat layers 14 with respect to the resin substrate 12. Where the silane coupling agent is used in an amount more than 5 parts by weight with respect to 100 parts by weight of the base agent, there arise risks of the insufficient adhesiveness of the undercoat layers 14 with respect to the resin substrate 12 and the poor appearance of the undercoat layers 14. Where the silane coupling agent is used in an amount less than 2 parts by weight with respect to 100 parts by weight of the base agent, there arises a risk that a sufficiently strong bond between the undercoat layers 14 and the topcoat layers 16 via the silane coupling agent cannot be assured, as described later, resulting in a failure to sufficiently improve the weather-proofness of the resin glass 10.

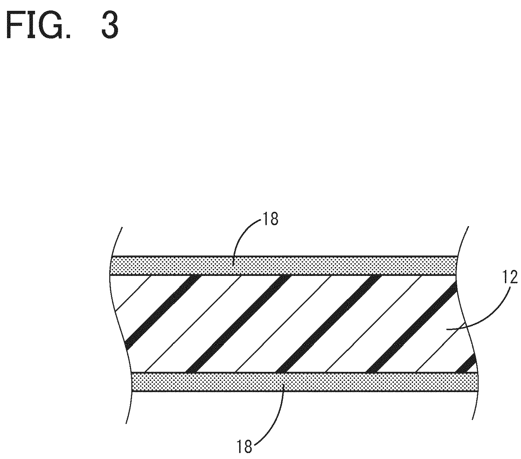

Subsequently, mixture layers 18 are formed of the liquid mixture of the base agent, the curing agent and the silane coupling agent, on the respective front and back surfaces of the resin substrate 12, as shown in Fig. 3. The mixture layers 18 are cured through a reaction between the base agent and the curing agent, whereby the fluorine-containing urethane resin is formed. At this time, the isocyanate group of the silane coupling agent and the hydroxyl group of the base agent of the fluorine-containing urethane resin are reacted with each other and bonded to each other, while the reaction between the base agent and the curing agent is in progress.

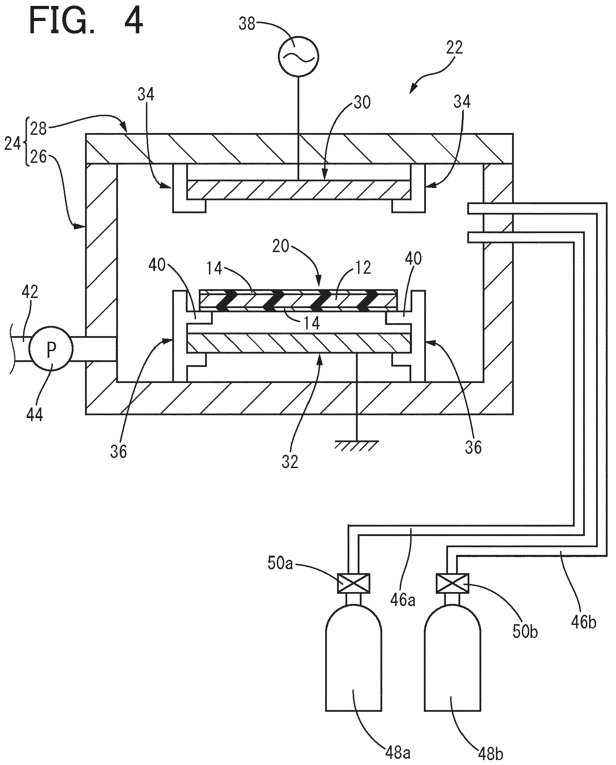

Thus, the undercoat layers 14 are formed, on the respective front and back surfaces of the resin substrate 12, of the mixture of the fluorine-containing urethane resin and the silane coupling agent, which are strongly bonded to each other, whereby an intermediate laminar body 20 (shown in Fig. 4) is obtained.

In this respect, it is noted that the mixture layers 18 are formed on the respective opposite surfaces of the resin substrate 12 by a method which is not particularly limited. For example, there may be adequately employed: a method of coating the opposite surfaces of the resin substrate 12 with the liquid mixture of the base agent, curing agent and silane coupling agent, by using a roller or a brush; a method of spraying the liquid mixture onto the opposite surfaces of the resin substrate 12, by using a spray gun or the like; and a method of performing a dipping operation. Also, a method of curing the mixture layers 18 is selected from various known methods such as a method of heating the mixture layers 18 and a method of irradiating the mixture layers 18 with an ultraviolet ray, depending on kinds of the base agent and the curing agent used to form the mixture layers 18. Where the mixture layers 18 are cured by heating, the mixture layers 18 are heated at a temperature within a range of about 80-130°C, for example.

After the intermediate laminar body 20 is obtained, the topcoat layers 16 are formed on the respective two undercoat layers 14 of the intermediate laminar body 20. The topcoat layers 16 are formed by using a plasma CVD device 22 constructed as shown in Fig. 4, for example.

As is apparent from Fig. 4, the plasma CVD device 22 used in this embodiment has a basic structure similar to that of the conventional plasma CVD device for a parallel-plate method. Namely, the plasma CVD device 22 has a vacuum chamber 24 as a reaction chamber. The vacuum chamber 24 has a chamber body 26 in the form of a box which is open upwards and a lid member 28 which covers the opening of the chamber body 26 so as to air-tightly seal the inside of the chamber body 26.

Within the vacuum chamber 24, a cathode electrode 30 and an anode electrode 32 are disposed in opposition to each other in the vertical direction with a predetermined distance therebetween. The cathode electrode 30 is supported by upper holders 34 provided on the lid member 28, while the anode electrode 32 is supported by lower holders 36 provided on the bottom of the chamber body 26. The cathode electrode 30 is electrically connected to a high-frequency power source 38 disposed outside the vacuum chamber 24. Support protrusions 40 are formed integrally with the lower holders 36 supporting the anode electrode 32, so as to support the intermediate laminar body 20 at a position between the cathode electrode 30 and the anode electrode 32.

An evacuation pipe 42 is provided so as to extend through a side wall of the chamber body 26, so that the inside and the outside of the chamber body 26 are communicated with each other through the evacuation pipe 42. By an operation of a vacuum pump 44 provided on the evacuation pipe 42, a gas within the chamber body 26 is evacuated from the chamber body 26 through the evacuation pipe 42, to reduce the pressure within the vacuum chamber 24.

A first introduction pipe 46a and a second introduction pipe 46b are provided so as to extend through a side wall of the chamber body 26, so that one of opposite end portions of each of the first and second introduction pipes 46a and 46b is open within the vacuum chamber 24. The other end portion of the first introduction pipe 46a is connected to a first cylinder 48a in which a monosilane gas which is a kind of a silicon compound gas is accommodated at a pressure higher than the atmospheric pressure. The other end portion of the second introduction pipe 46b is connected to a second cylinder 48b in which an oxygen gas is accommodated at a pressure higher than the atmospheric pressure. The first introduction pipe 46a is connected to the first cylinder 48a via a first shut-off valve 50a, while the second introduction pipe 46b is connected to the second cylinder 48b via a second shut-off valve 50b.

The monosilane gas accommodated in the first cylinder 48a is used as a raw material gas for forming the topcoat layers 16 of SiO₂, while the oxygen gas accommodated in the second cylinder 48b is used as a reactant gas for forming the topcoat layers 16, as described later. Accordingly, the gases accommodated in the first and second cylinders 48a and 48b are not particularly limited, as long as the gases can be used as the raw material gas and the reactant gas for forming the topcoat layers 16.

As the raw material gas accommodated in the first cylinder 48a, any one of or any combination of gases of inorganic silicon compounds such as monosilane (SiH₄) and disilane (Si₂H₆) is generally used. As well as the gases of the inorganic silicon compounds, gases of organic silicon compounds may also be used as the raw material gas accommodated in the first cylinder 48a. Examples of the gases of the organic silicon compounds include gases of: siloxanes such as tetramethyldisiloxane, hexamethyldisiloxane and hexamethylcyclotrisiloxane; silanes such as methoxytrimethylsilane, ethoxytrimethylsilane, dimethoxydimethylsilane, dimethoxydiethylsilane, dimethoxydiphenylsilane, trimethoxysilane, trimethoxymethylsilane, trimethoxyethylsilane, trimethoxypropylsilane, triethoxymethylsilane, triethoxydimethylsilane, triethoxyethylsilane, triethoxyphenylsilane, tetramethylsilane, tetramethoxysilane and tetraethoxysilane; and silazanes such as hexamethyldisilazane and tetramethyldisilazane. Any one of or any combination of the above-indicated gases of the organic silicon compounds may be used.

The reactant gas accommodated in the second cylinder 48b is adequately selected depending on the kind of the silicon compound of the topcoat layers 16. For example, where the topcoat layers 16 are formed of SiON and Si₃N₄, the oxygen gas, a nitrogen gas, an ammonia gas and the like are used as the reactant gas accommodated in the second cylinder 48b.

By using the plasma CVD device 22 constructed as described above, the topcoat layers 16 are formed on the respective undercoat layers 14 formed on the respective opposite surfaces of the resin substrate 12 to produce the intended resin glass 10 as described below. Initially, the intermediate laminar body 20 obtained as described above is accommodated in the vacuum chamber 24, such that the intermediate laminar body 20 is supported by the support protrusions 40 of the lower holders 36, and disposed between the cathode electrode 30 and the anode electrode 32. Then, the upper opening of the chamber body 26 is covered by the lid member 28, so that the inside of the vacuum chamber 24 is air-tightly sealed. Subsequently, the vacuum pump 44 is operated to reduce the pressure within the vacuum chamber 24 to about 10⁻⁵-10⁻³Pa, for example.

After the pressure within the vacuum chamber 24 is reduced to a predetermined value, the first shut-off valve 50a of the first cylinder 48a and the second shut-off valve 50b of the second cylinder 48b are opened, while the vacuum pump 44 is operated, whereby the monosilane gas within the first cylinder 48a is introduced into the vacuum chamber 24 through the first introduction pipe 46a, and the oxygen gas within the second cylinder 48b is introduced into the vacuum chamber 24 through the second introduction pipe 46b. Thus, the vacuum chamber 24 is charged with the monosilane gas and the oxygen gas.

After the vacuum chamber 24 is charged with the monosilane gas and the oxygen gas, and the pressure within the vacuum chamber 24 reaches a predetermined value, the high-frequency power source 38 is turned on, to apply a high-frequency current to the cathode electrode 30 within the vacuum chamber 24, whereby an electrical discharge phenomenon is caused to take place between the cathode electrode 30 and the anode electrode 32, and the monosilane gas and the oxygen gas filling the vacuum chamber 24 are turned into plasma. Thus, monosilane gas plasma and oxygen gas plasma are generated within the vacuum chamber 24.

A reaction between the monosilane gas plasma and the oxygen gas plasma (reaction between the monosilane gas and the oxygen gas by a plasma CVD process) is caused to take place in the space within the vacuum chamber 24 and on the opposite surfaces of the intermediate laminar body 20, whereby SiO₂ is generated and deposited on the entirety of each of the surfaces of the intermediate laminar body 20. After a predetermined length of time has passed after the first and second shut-off valves 50a and 50b are opened, the first and second shut-off valves 50a and 50b are closed. Thus, the topcoat layers 16 in the form of the plasma CVD layers of SiO₂ are formed at a sufficiently high deposition rate, on the respective undercoat layers 14 formed on the respective opposite surfaces of the resin substrate 12. The thickness of the topcoat layers 16 is determined by a period of time for which the first and second shut-off valves 50a and 50b are held open.

At this time, while the reaction between the monosilane gas plasma and the oxygen gas plasma is in progress, a reaction is caused to take place between the silanol generated by dissociation and conversion of the monosilane gas into the plasma and the silanol generated by hydrolysis of the methoxy group of the silane coupling agent in the undercoat layers 14, whereby the siloxane bond having the bond energy larger than the ultraviolet energy is formed between the silicon compound of the topcoat layers 16 in the form of the plasma CVD layers of SiO₂ and the silane coupling agent in the undercoat layers 14.

Thus, the topcoat layers 16 are formed on the respective undercoat layers 14, such that the topcoat layers 16 are strongly bonded to the silane coupling agent in the undercoat layers 14 in which the fluorine-containing urethane resin and the silane coupling agent are strongly bonded to each other, whereby the intended resin glass 10 is obtained.

It will be understood from the foregoing description that in the resin glass 10 of this embodiment, the fluorine-containing urethane resin of the undercoat layers 14 and the silicon compound of the topcoat layers 16 are strongly bonded to each other via the silane coupling agent, whereby adhesiveness between the undercoat layers 14 and the topcoat layers 16 can be advantageously improved.

In the resin glass 10 of this embodiment, the fluorine-containing urethane resin of the undercoat layers 14 has a larger number of bonds between the fluorine atoms and the carbon atoms, which bonds have the bond energy larger than the ultraviolet energy. Further, the ultraviolet irradiation is advantageously prevented by a blocking action of the fluorine atoms, in the parts of the fluorine-containing urethane resin where the fluorine atoms and the carbon atoms are bonded to each other, and in the parts of the fluorine-containing urethane resin where the carbon atoms and the hydrogen atoms are bonded to each other. As a result, it is possible to effectively prevent or reduce cutting of bonds between the atoms constituting the resin of the undercoat layers 14 due to the ultraviolet irradiation, particularly, cutting of the bonds between the fluorine atoms and the carbon atoms, which bonds constitute the main organic backbone of the resin of the undercoat layers 14.

Therefore, in the resin glass 10 of this embodiment, it is possible to advantageously prevent cracking of the undercoat layers 14 due to the ultraviolet irradiation, peeling of the topcoat layers 16 from the undercoat layers 14, and cracking of the topcoat layers 16 due to its peeling from the undercoat layers 14. As a result, the resin glass 10 can extremely effectively exhibit further improved weather-proofness.

By the method of producing the resin glass 10 of this embodiment, the resin glass 10 having excellent characteristics as described above can be extremely easily produced by merely performing a simple operation of adding the silane coupling agent to the material of the undercoat layers 14, in addition to operations similar to those of the conventional production of the resin glass, without any other extra workload.

Although the specific embodiment of the invention has been described for illustrative purpose only, the invention is by no means limited to the details of the illustrated embodiment.

For example, in the above-described embodiment, the undercoat layers 14 and the topcoat layers 16 are formed on the respective front and back surfaces of the resin substrate 12. However, it is possible to form the undercoat layer 14 and the topcoat layer 16 on only one of the opposite surfaces of the resin substrate 12.

In the above-described embodiment, the topcoat layers 16 are the plasma CVD layers of the silicon compound. However, the process for forming the topcoat layers 16 is not particularly limited as long as the process permits formation of the topcoat layers 16 in the form of thin films of the silicon compound. Accordingly, the topcoat layers 16 in the form of the thin films of the silicon compound may be formed by a so-called PVD process such as a vapor-deposition process and sputtering, and a CVD process other than the plasma CVD process. Where the topcoat layers 16 are formed as the plasma CVD layers of the silicon compound, a plasma CVD device having a known structure other than that of the plasma CVD device used in the illustrated embodiment may be adequately used to form the topcoat layers 16. For example, it is possible to use a plasma CVD device for an inductive-coupling method and a plasma CVD device having a plasma generator for generating a plasma arc.

In the above-described embodiment, the resin glass and the method of its production are illustrated as the specific examples of the invention. However, it goes without saying that the invention is advantageously applicable to any resin product in which the undercoat layer in the form of the resin thin film and the topcoat layer formed of the silicon compound are formed on the resin substrate formed of polycarbonate, and to the method of producing such resin product.

It goes without saying that the invention may be embodied with various other changes, modifications and improvements, which are not illustrated herein, and which may occur to those skilled in the art, without departing from the spirit of the invention, and that those changes, modification and improvements are also within the scope of the invention.

### EXAMPLES

To clarify the invention more specifically, a representative example of the invention will be described. However, it goes without saying that the invention is by no means limited to the details of the illustrated example, and it is to be understood that the invention may be embodied with various changes, modifications and improvements, which are not illustrated herein, and which may occur to those skilled in the art, without departing from the spirit of the invention.

Initially, two transparent resin substrates in the form of rectangular flat plates each having a length of 100mm, a width of 100mm and a thickness of 5mm were formed of a commercially available polycarbonate resin by a known injection molding method. On the other hand, there were prepared: a predetermined amount of a base agent in the form of a butyl acetate solution of a copolymer of tetrafluoroethylene and an ethylene-based compound in which two of four hydrogen atoms of ethylene are substituted with hydroxyl groups (-OH groups); and a predetermined amount of a curing agent in the form of a butyl acetate solution of an isocyanurate body of hexamethylenediisocyanate. Further, there was provided a predetermined amount of a commercially available aqueous solution of a silane coupling agent having a reactive functional group in the form of an isocyanate group and a hydrolyzable group in the form of a methoxy group.

The thus provided base agent, curing agent and aqueous solution of the silane coupling agent were mixed together at a ratio of 100:13:3 on the weight basis, to obtain a liquid mixture. The entire surface of one of the two resin substrates formed as described above was coated with the liquid mixture, and the resin substrate was heated at 120°C to cure the liquid mixture. Thus, an undercoat layer was formed of a mixture of a fluorine-containing urethane resin and the silane coupling agent, on the entirety of each of the opposite surfaces of the resin substrate, whereby an intermediate laminar body A was obtained. In this respect, it is noted that a thickness of the undercoat layer of the intermediate laminar body A was 20µm.

After the intermediate laminar body A was accommodated in a vacuum chamber of a plasma CVD device constructed as shown in Fig. 4, the inside of the vacuum chamber was placed in a vacuum state. At this time, a pressure within the vacuum chamber was set at 10⁻⁴Pa.

Subsequently, a monosilane gas and an oxygen gas were introduced into the vacuum chamber, such that a constant amount of each gas was introduced into the vacuum chamber per unit time, whereby the vacuum chamber was charged with the monosilane gas and the oxygen gas. Then, a high-frequency current was applied from a high-frequency power source to a cathode electrode, to generate oxygen gas plasma and monosilane gas plasma. By the reaction between the thus generated oxygen gas plasma and monosilane gas plasma, a topcoat layer was formed of SiO₂ on the surface of the undercoat layer of the intermediate laminar body A. In this respect, it is noted that a thickness of the topcoat layer of the intermediate laminar body A was 1µm.

Thus, a resin glass as shown in Fig. 1 was obtained as a test specimen 1, in which the undercoat layer formed of the mixture of the fluorine-containing urethane resin and the silane coupling agent, and the topcoat layer formed of SiO₂ are formed, in this order of description, on the surface of the resin substrate formed of polycarbonate.

On the other hand, for the purpose of comparison, the entire surface of the other of the two resin substrates formed as described above was coated with a commercially available thermosetting-acrylic-resin coating material, and the resin substrate was heated at 80°C, to cure the thermosetting-acrylic-resin coating material. Thus, an undercoat layer was formed of the acrylic resin, on the entirety of each of the opposite surfaces of the resin substrate, whereby an intermediate laminar body B was obtained. In this respect, it is noted that a thickness of the undercoat layer of the intermediate laminar body B was 20µm.

The intermediate laminar body B was accommodated in the vacuum chamber of the plasma CVD device constructed as shown in Fig. 4. Then, a topcoat layer was formed of SiO₂ on the surface of the undercoat layer of the intermediate laminar body B, by performing operations similar to those employed to form the topcoat layer of SiO₂ on the surface of the undercoat layer of the intermediate laminar body A. These operations were performed in conditions similar to those described above with respect to the intermediate laminar body A. In this respect, it is noted that a thickness of the topcoat layer of the intermediate laminar body B was 1µm.

Thus, a resin glass having a structure similar to that of the conventional resin glass was obtained as a test specimen 2, in which the undercoat layer formed of the acrylic resin and the topcoat layer formed of SiO₂ are formed, in this order of description, on the surface of the resin substrate formed of polycarbonate.

By using the resin glasses obtained as the test specimens 1 and 2 as described above, a test for evaluating adhesiveness between the topcoat layer and the undercoat layer, and a test for evaluating the weather-proofness of the resin glasses were conducted as described below. Results of the tests are indicated in Table 1 given below.

### <Adhesion Test>

An adhesion test was conducted according to JIS K5600-5-6. Where the resin glass subjected to the adhesion test did not suffer from peeling, the resin glass was evaluated as having a high degree of adhesiveness between the topcoat layer and the undercoat layer, and the test result is indicated as "Good". Where the resin glass subjected to the adhesion test suffered from a slight peeling, the resin glass was evaluated as having a slightly lower degree of adhesiveness between the topcoat layer and the undercoat layer, and the test result is indicated as "Fair".

### <Weather-proofness>

A weather-proofness test was conducted according to JIS R3211 and 3212. Where the resin glass subjected to the weather-proofness test did not suffer from cracking of the topcoat layer and the undercoat layer, the resin glass was evaluated as having a high degree of weather-proofness, and the test result is indicated as "Good". Where the resin glass subjected to the weather-proofness test suffered from cracking of the topcoat layer and the undercoat layer, the resin glass was evaluated as having a low degree of weather-proofness, and the test result is indicated as "Poor".

**[Table 1]**

| | Test specimen 1 | Test specimen 2 |
|---|---|---|
| Adhesion test result | Good | Fair |
| Weather-proofness test result | Good | Poor |

As is apparent from the results in Table 1, the resin glass of the test specimen 1 is evaluated as "Good" in the adhesion test and the weather-proofness test. In the test specimen 1, the undercoat layer formed of the mixture of the fluorine-containing urethane resin and the silane coupling agent, and the topcoat layer formed of SiO₂ are formed, in this order of description, on the surface of the resin substrate. On the other hand, the resin glass of the test specimen 2 is evaluated as "Fair" in the adhesion test, and as "Poor" in the weather-proofness test. In the test specimen 2, the undercoat layer formed of the acrylic resin and the topcoat layer formed of SiO₂ are formed, in this order of description, on the surface of the resin substrate. Those results show the fact that the resin glass having the structure according to the invention exhibits excellent properties in terms of both of the adhesiveness between the topcoat layer and the undercoat layer, and the weather-proofness.

### NOMENCLATURE OF REFERENCE SIGNS

| | |
|---|---|
| 10: Resin glass | 12: Resin substrate |
| 14: Undercoat layer | 16: Topcoat layer |
| 22: Plasma CVD device | |

## Claims

1. A resin product wherein an undercoat layer in the form of a resin thin film is formed on a surface of a resin substrate in the form of a resin molded article of polycarbonate, and a topcoat layer is formed of a silicon compound on the undercoat layer, **characterized in that**:
the undercoat layer is formed of a mixture of: a silane coupling agent having a reactive functional group and a hydrolyzable organic group; and a fluorine-containing resin having a reactive group which can be bonded to the reactive functional group of the silane coupling agent;
the reactive functional group of the silane coupling agent is bonded to the reactive group of the fluorine-containing resin; and
the hydrolyzable organic group of the silane coupling agent is bonded to the silicon compound of the topcoat layer.

2. The resin product according to claim 1, wherein the reactive functional group of the silane coupling agent is an isocyanate group or an epoxy group, and the reactive group of the fluorine-containing resin is a hydroxyl group.

3. A method of producing a resin product wherein an undercoat layer in the form of a resin thin film is formed on a surface of a resin substrate in the form of a resin molded article of polycarbonate, and a topcoat layer is formed of a silicon compound on the undercoat layer, the method comprising the steps of:
providing the resin substrate;
forming the undercoat layer on the surface of the resin substrate by using a mixture of: a silane coupling agent having a reactive functional group and a hydrolyzable organic group; and a fluorine-containing resin having a reactive group which can be bonded to the reactive functional group of the silane coupling agent, such that the reactive functional group of the silane coupling agent is bonded to the reactive group of the fluorine-containing resin; and
forming the topcoat layer on the undercoat layer by using the silicon compound, such that the silicon compound is bonded to the hydrolyzable organic group of the silane coupling agent contained in the undercoat layer.
